# EUROPEAN PATENT APPLICATION

(11) **EP 1 852 915 A1**
(43) Date of publication of application: **07.11.2007**
(21) Application number: 07107343.1
(22) Date of filing: 02.05.2007
(51) Int. Cl.: H01L 27/32

(54) **Organic light emitting display device**

(30) Priority: 03.05.2006 KR 20060040219
(71) Applicant: Samsung SDI Co., Ltd., Suwon-si, Gyeonggi-do (KR)
(72) Inventor: Yang, Sun-A, Samsung SDI Co., Ltd., Gyeonggi-do (KR); Kang, Won Seok, Samsung SDI Co., Ltd., Gyeonggi-do (KR); Lee, Eun Jung, Samsung SDI Co., Ltd., Gyeonggi-do (KR); Oh, Youn Chul, Samsung SDI Co., Ltd., Gyeonggi-do (KR)
(74) Representative: Walaski, Jan Filip

(57) **Abstract**

An organic light-emitting display device (200), includes a substrate (210), a thin film transistor (230) on the substrate (210), a passivation layer (250) on the thin film transistor (230), an organic light-emitting diode (260) on the passivation layer (250) and electrically connected to the thin film transistor (230), a photo sensor (240) between the substrate (210) and the organic light-emitting diode (260), and a light blocking layer (265) on the passivation layer (250).

## Description

The present invention relates to an organic light-emitting display device and a method of manufacturing the same. In particular, the present invention relates to an organic light-emitting display device having a light blocking layer capable of increasing a light absorption rate of a photo sensor and a method of manufacturing the same.

In general, an organic light-emitting display device is a flat panel display device, where voltage may be applied to a plurality of layers interposed between two electrodes, i.e., an anode and a cathode, to combine electrons and holes to form images. In particular, the conventional organic light-emitting display device may include a hole injection layer (HIL), a hole transporting layer (HTL), at least one organic light-emitting layer, an electron injection layer (EIL) and an electron transporting layer (ETL). Accordingly, holes from the anode may be injected into the HIL, so the injected holes may be transported into the organic light-emitting layer through the HTL. Similarly, electrons may be injected from the cathode into the EIL, so the injected electrons may be transported into the organic light-emitting layer through the ETL. The transported holes and electrons may combine with one another in the organic light-emitting layer, to form excitons and, thereby, emit visible light and form images.

The conventional organic light-emitting layer of the organic light-emitting display device may deteriorate over time and, thereby, reduce brightness of light emitted therefrom and/or modify color coordinates thereof. Reduced brightness of light emitted from the organic light-emitting layer may decrease the image quality of the organic light-emitting display device and its overall lifespan. Attempts have been made to improve the brightness of the organic light-emitting display device by incorporating a photo sensor therein. However, the conventional photo sensor may have a low light absorption rate due to light interference, thereby providing a limited brightness control of the organic light-emitting display device.

Accordingly, there exists a need for an organic light-emitting display device with a photo sensor capable of controlling brightness thereof, while exhibiting an improved light absorption rate.

The present invention is therefore directed to an organic light-emitting display device and a method of manufacturing the same, which substantially overcome one or more of the disadvantages of the related art.

It is a feature of the present invention to provide an organic light-emitting display device with a light blocking layer capable of increasing a light absorption rate of a photo sensor therein.

It is another feature of the present invention to provide a method of manufacturing an organic light-emitting display device with a light blocking layer capable of increasing a light absorption rate of a photo sensor therein.

At least one of the above and other features and advantages of the present invention may be realized by providing an organic light-emitting display device, including a substrate, a thin film transistor on the substrate, a passivation layer on the thin film transistor, an organic light-emitting diode (OLED) on the passivation layer and electrically connected to the thin film transistor, a photo sensor between the substrate and the OLED, and a light blocking layer on the passivation layer. The light blocking layer may include a metal having low reflectivity. The metal may be molybdenum or chromium. Alternatively, the light blocking layer may include a metal insulator hybrid layer.

The light blocking layer may be a single continuous film. Alternatively, the light blocking layer may include a plurality of discontinuous segments. The light blocking layer may be capable of minimizing interfering light absorbed by the photo sensor.

The photo sensor may be horizontally spaced apart from the thin film transistor. The photo sensor may include an N-type doping region, a P-type doping region horizontally spaced apart from the N-type doping region, and an intrinsic region between the N-type doping region and the P-type doping region. The photo sensor may be capable of absorbing light emitted from the OLED and converting the absorbed light into electrical signals. The electrical signals may be capable of controlling luminance of the light generated by the OLED.

The OLED may have a rear light-emitting structure. The OLED may include a first electrode layer, an organic light-emitting layer and a second electrode layer.

In another aspect of the present invention, there is provided a method of manufacturing an organic light-emitting display device, including forming a thin film transistor on a substrate, forming a photo sensor on the substrate, forming a passivation layer on the thin film transistor, forming an OLED on the passivation layer, and forming a light blocking layer on the passivation layer.

Forming the light blocking layer may include depositing a metal or an opaque insulating material to a thickness of about 100 angstroms (10nm) to about 5000 angstroms (500nm). Forming the light blocking layer may include depositing a metal having low reflectivity.

Additionally, forming the light blocking layer may include depositing a plurality of discontinuous segments on the passivation layer. Each predetermined number of segments of the plurality of segments may be arranged into a geometrical shape.

Alternatively, forming the light blocking layer may include depositing a single continuous layer on the passivation layer.

The above and other features and advantages of the present invention will become more apparent to those of ordinary skill in the art by describing in detail exemplary embodiments thereof with reference to the attached drawings, in which:
FIG. 1 illustrates a cross sectional view of an organic light-emitting display device according to an embodiment of the present invention;
FIGS. 2A-2B illustrate plane views of an organic light-emitting display device according to other embodiments of the present invention; and
FIGS. 3A-3C illustrate sequential steps in a process of manufacturing an organic light-emitting display device according to an embodiment of the present invention.

The present invention will now be described more fully hereinafter with reference to the accompanying drawings, in which exemplary embodiments of the invention are illustrated. The invention may, however, be embodied in different forms and should not be construed as limited to the embodiments set forth herein. Rather, these embodiments are provided so that this disclosure will be thorough and complete, and will fully convey the scope of the invention to those skilled in the art.

In the figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

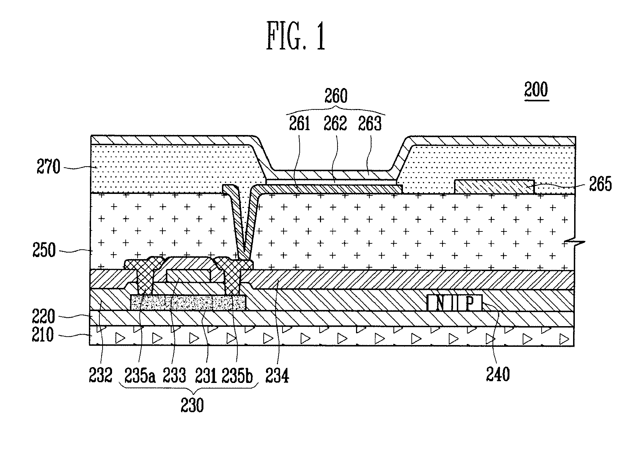

Hereinafter, an exemplary embodiment of an organic light-emitting display device according to the present invention will be described in more detail below with reference to FIG. 1. As illustrated in FIG. 1, an organic light-emitting display device 200 according to an embodiment of the present invention may include a substrate 210, a thin film transistor 230, a passivation layer 250, an organic light-emitting diode (OLED) 260, a photo sensor 240, and a light blocking layer 265 on the passivation layer 250.

The substrate 210 of the organic light-emitting display device 200 according to an embodiment of the present invention may be made of any insulating material, e.g., glass, plastic, silicon, synthetic resin, and so forth, as determined by one of ordinary skill in the art. Preferably, the substrate 210 may be transparent e.g., a glass substrate. Additionally, the substrate 210 may be formed to have a pixel region, i.e., an area capable of displaying images, and a non-pixel region. The substrate 210 may include a buffer layer 220 formed thereon. The buffer layer 220 may be selectively formed of silicon nitride (SiNx) or silicon oxide (SiO₂). The buffer layer 210 may minimize diffusion of impurities into the thin film transistor 230 or into the photo sensor 240 thereabove during post-processing thereof.

The thin film transistor 230 of the organic light-emitting display device 200 according to an embodiment of the present invention may include a semiconductor layer 231, an insulating layer 232, a gate 233, an inter-layer insulating layer 234, and source/drain 235a /235b.

The semiconductor layer 231 of the thin film transistor 230 may be formed to have a predetermined pattern on the buffer layer 220 in an area corresponding to the non-pixel region of the substrate 210. In particular, the semiconductor layer 231 may be formed by crystallizing an amorphous silicon layer into a low temperature polysilicon (LTPS) via, for example, laser irradiation.

The gate insulating layer 232 of the thin film transistor 230 may be formed on the semiconductor layer 231, i.e., between the semiconductor layer 231 and the gate 233. More specifically, the insulating layer 232 may be deposited on the buffer layer 220 and over the semiconductor layer 231 and the photo sensor 240, as illustrated in FIG. 1, such that a portion of the insulating layer 232 may be positioned on the buffer layer 220 between the semiconductor layer 231 of the thin film transistor 230 and the photo sensor 240 to separate therebetween.

The gate 233 of the thin film transistor 230 may be disposed in a predetermined pattern on the insulating layer 232 in an area corresponding to the non-pixel region of the substrate 210, and the inter-layer insulating layer 234 may be formed thereon. The source/drain 235a and 235b of the thin film transistor 230 may be formed on the inter-layer insulating layer 234 and may be electrically connected with both sides of the semiconductor layer 231 through a contact hole formed in the inter-layer insulating layer 234.

The OLED 260 of the organic light display device 200 according to an embodiment of the present invention may include a first electrode layer 261, a second electrode layer 263, and an organic light-emitting layer 262 therebetween. The OLED 260 may be electrically connected to the thin film transistor 230. In particular, the first electrode layer 261 may be electrically connected with either the source 235a or the drain 235b of the thin film transistor 230 through a via hole formed on the passivation layer 250. The second electrode layer 263 may be formed on the first electrode layer 261, such that the organic light-emitting layer 262 may be disposed therebetween. The first and second electrode layers 261 and 263 may be made of a same metal material, e.g., indium-tin-oxide (ITO), indium-zinc-oxide (IZO), zinc oxide (ZnO), and so forth.

The organic light-emitting layer 262 of the OLED 260 may be formed to expose a part of the first electrode layer 261. The organic light-emitting layer 262 may further include at least one or more of a hole injection layer (HIL), a hole transporting layer (HTL), an electron injection layer (EIL) and an electron transporting layer (ETL). Accordingly, the organic light-emitting layer 262 may generate light when holes and electrons are injected therein.

The photo sensor 240 of the light-emitting display device 200 according to an embodiment of the present invention may be any suitable optical sensor capable of receiving a light signal and converting the light signal into an electrical signal, e.g., current or voltage. For example, the photo sensor 240 may be a semiconductor device having a light detecting function, such as a diode with a light detecting function at a junction thereof, i.e., a photo diode. In other words, since absorption of photons may generate electrons/holes, an amount of light detected by a diode functioning as the photo sensor 240 may affect the amount of charge generated in the photo sensor 240, thereby converting light signals into electrical signals with respect to changes in current flow in the photo sensor 240.

The photo sensor 240 may be formed on the substrate 210 in an area corresponding to the pixel region thereof. The photo sensor 240 may have a structure of a Pi(intrinsic)-N and, therefore, may have an N-type doping N region for applying a positive voltage, a P-type doping P region for applying a negative voltage, and an intrinsic region therebetween. The N-type doping N region, the P-type doping P region, and the intrinsic region may be positioned on a same plane, e.g., positioned in direct communication with the buffer layer 220.

An anode voltage may be applied to the P-type doping region P and a cathode voltage may be applied to the N-type doping region N, thereby bringing the intrinsic region between the P-type and the N-type doping regions to a state of full depletion. At this state, the photo sensor 240 may absorb light emitted from the OLED 260 to generate charges and convert them into electrical signals.

The electrical signals output by the photo sensor 240 in response to the absorbed light signals may represent actual luminance values of the organic light-emitting layer 262 and be compared to a predetermined luminance reference value. Any deviation of the actual luminance values from the predetermined luminance reference value may be controlled by the photo sensor 240, thereby facilitating constant luminance output from the organic light-emitting layer 262.

For example, an electrical signal may be output from the photo sensor 240 with respect to light absorbed therein from the organic light-emitting layer 262 and supplied into a comparison part. When the electrical signal output from the photo sensor 240 has a luminance value below the predetermined luminance reference value, the comparison part may generate a control signal to increase the luminance of light generated by the organic light-emitting layer 262. Similarly, when the electrical signal output from the photo sensor 240 has a luminance value above the predetermined luminance reference value, the comparison part may generate a control signal to decrease the luminance of light generated by the organic light-emitting layer 262. Alternatively, electric signals, i.e., current or voltage, output from the photo sensor 240 with respect to light absorbed therein may be input into a controller part, so that the controller may output a respective control signal for controlling the luminance of the organic light-emitting layer 262 with respect to the light emitted therefrom.

The passivation layer 250 of the organic light-emitting display device 200 according to an embodiment of the present invention may be formed on the thin film transistor 230 by depositing a layer of, e.g., a nitride film or an oxide film. In particular, the passivation layer 250 may be positioned between the thin film transistor 230 and the OLED 260, and a portion of the passivation layer 250 may be etched to expose one of the source and drain regions 235a/235b in order to provide a connection between the thin film transistor 230 and the OLED 260.

The light blocking layer 265 of the organic light-emitting display device 200 according to an embodiment of the present invention may be formed on at least one predetermined region of the passivation layer 250, as illustrated in FIG. 1, of an opaque metal having a relatively low reflectivity, e.g., chromium (Cr), molybdenum (Mo), and so forth, or an opaque insulating material, e.g., chromium oxide (CrOx), molybdenum oxide (MoOx), and so forth. Alternatively, a metal insulator hybrid layer (MIHL) may be used. In particular, the MIHL may be a transparent film, e.g., silicon oxide (SiO₂), silicon nitride (SiNx), indium-titanium-oxide (ITO), and so forth, or a metal film, e.g., aluminum (Al), chromium (Cr), molybdenum (Mo), tungsten (W), titanium (Ti), silver (Ag), copper (Cu), and so forth.

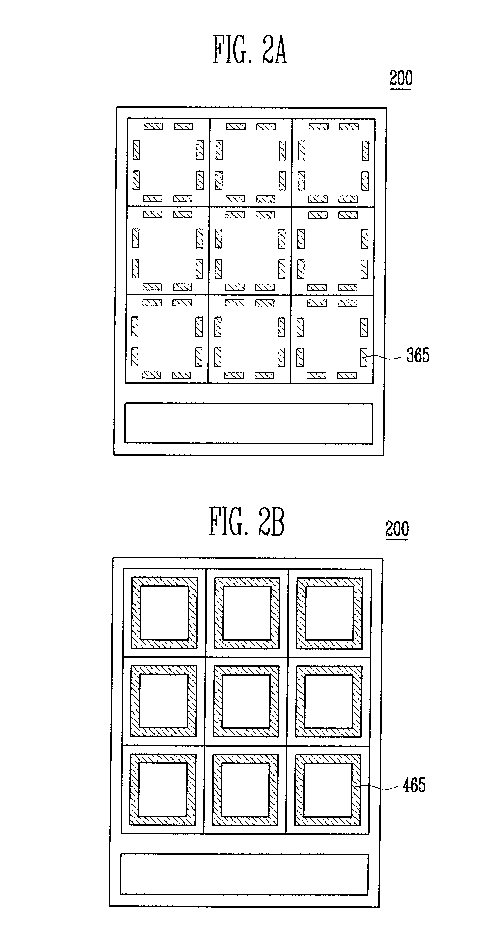

The light blocking layer 265 may be formed as a single, continuous layer film in an area corresponding to the pixel-area of the substrate 210, as illustrated in FIG. 1. However, other structures of the light blocking layer 265 are not excluded from the scope of the present invention. For example, as illustrated in FIG. 2A, a light blocking layer 365 may be formed as a plurality of discontinuous segments on several predetermined regions of the passivation layer 250, such that a predetermined number of segments, e.g., eight segments, may be arranged into any suitable shape as determined by one of ordinary skill in the art, e.g., a square. The light blocking layer 365 may include any number of shapes, while each shape may contain a plurality of segments. Alternatively, as illustrated in FIG. 2B, a light blocking layer 465 may be formed of any number of shapes, such that each shape may contain a single continuous segment.

The light blocking layer 265 may reduce or prevent interference of an inner or outer light, so that a light absorption rate of a photo sensor may be improved. In particular, the light blocking layer 265 may allow a portion of light generated by the organic light-emitting layer 262 to be cut off, such that the light is not transmitted to an exterior. Furthermore, by cutting off light from outside, light interfering with light absorbed by the photo sensor 240 may be minimized, thereby enhancing the amount of light absorbed by the photo sensor 240.

In other words, the light blocking layer 265 can operate both to reduce internally reflected light from the light-emitting layer 262 from reaching the sensor 240 and to block external light from reaching the sensor 240, as a result of which the sensitivity of the sensor to light from the light-emitting layer 262 can be improved.

The organic light-emitting display device 200 according to an embodiment of the present invention may further include a pixel-defining film 270. The pixel-defining film 270 may be formed on the first electrode layer 261 of an organic insulating material, e.g., an acryl-based compound, a polyamide, a polyimide, and so forth. The pixel-defining film 270 may include an opening (not shown) exposing part of the first electrode layer 261.

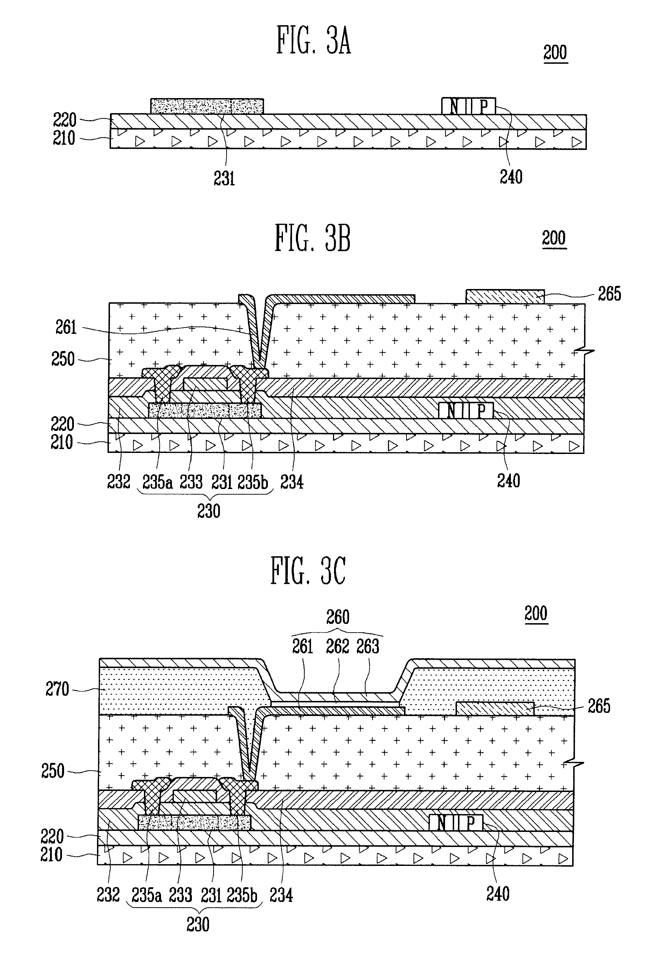

According to another exemplary embodiment of the present invention illustrated with reference to FIGS. 3A-3C, a method for manufacturing the organic light-emitting display device 200 previously described with respect to FIG. 1 will be described in detail below.

First, as illustrated in FIG. 3A, the buffer layer 220 may be formed on the substrate 210 by depositing a nitride film, an oxide film, or a transparent insulating material by, e.g., plasma enhanced chemical vapor deposition (PECVD), to a thickness of about 3000 angstroms (300nm).

Next, as further illustrated in FIG. 3A, the semiconductor layer 231 of the thin film transistor 230 and the photo sensor 240 may be formed on the buffer layer 220. In particular, the semiconductor layer 231 may be formed in a predetermined pattern on the buffer layer 220 by depositing silicon or an organic material via, e.g., chemical vapor deposition (CVD), to a thickness of about 300 to about 2000 angstroms (30 to 200nm). The semiconductor layer 231 may be patterned in any shape as determined by one of ordinary skill in the art, e.g., an island shape.

The photo sensor 240 may be formed on the buffer layer 220 in an area corresponding to the pixel region of the substrate 210, i.e., spaced apart from the thin film transistor 230 at a predetermined interval, such that the photo sensor 240 may receive a light generated by the organic light-emitting layer 262. More specifically, the photo sensor 240 may be formed by crystallizing amorphous silicon into polycrystalline silicon via a heat treatment. Next, high concentrations of an N-type dopant and a P-type dopant may be injected into the first and second regions of the polycrystalline silicon, respectively, to form an N-type doping and a P-type doping regions, respectively. The first and second regions of the polycrystalline silicon, i.e., N-type and P-type doping regions, may be horizontally spaced apart. Next, as illustrated in FIG. 3B, the gate insulating layer 232 of the thin film transistor 230 may be formed on the semiconductor layer 231 by depositing an oxide film or a nitride film via PECVD to a thickness of about 700 angstroms (70nm) to about 1500 angstroms (150nm). The inter-layer insulating layer 234 may be formed on the gate 233 by the same method as the gate insulating layer 232.

The gate 233 of the thin film transistor 230 may be formed by depositing a conductive metal, e.g., aluminum (Al) or aluminum alloy, molybdenum tungsten (MoW), molybdenum (Mo), copper (Cu), silver (Ag) or silver alloy, indium tin oxide (ITO), indium zinc oxide (IZO), or a semitransparent metal on the gate insulating layer 232 to a thickness of about 2000 angstroms (200nm) to about 3000 angstroms (300nm) via, e.g., sputtering. The gate 233 may be patterned.

Next, the source/drain 235a/235b of the thin film transistor 230 may be formed on the inter-layer insulating layer 234. The source/drain 235a/235b may be electrically connected to both sides of the semiconductor layer 231 through a contact hole formed in the gate insulating layer 232 and the inter-layer insulating layer 234. The passivation layer 250 may be formed on the thin film transistor 230. In particular, the passivation layer 250 may be in contact with the inter-layer insulating layer 234 and be etched to form a via hole therein in order to expose either the source 235a or the drain 235b. The first electrode layer 261 of the OLED 260 may be deposited thereon and electrically connected with either the source 235a or the drain 235b through the via hole formed in the passivation layer 250.

The light blocking layer 265 may be formed on the passivation layer 250 in a region corresponding to the pixel area of the substrate 210. In particular, the light blocking layer 265 may be formed by depositing, e.g., sputtering, metal with a relatively low reflectively, e.g., chromium (Cr), molybdenum (Mo), and so forth, or an opaque insulating material, e.g., chromium oxide (CrOx), molybdenum oxide (MoOx), and so forth, on the passivation layer 250 to a thickness of about 100 angstroms (10nm) to about 5000 angstroms (500nm). The light blocking layer 265 may be patterned in any suitable shape as determined by one of ordinary skill in the art.

Next, as illustrated in FIG. 3C, the pixel-defining film 270 may be formed by depositing an organic insulating material, e.g., acryl organic compound, a polyamide, a polyimide, and so forth, on the passivation layer 250, followed by exposure, development and etching processes. The pixel-defining film 270 may include an opening exposing at least part of the first electrode layer 261.

The OLED 260 may be positioned on the passivation layer 250 and electrically connected to any one of the source/drain regions 235a/235b. In particular, the first electrode layer 261 of the OLED 260 may be electrically connected with the source or drain regions 235a/235b via a hole formed in the passivation layer 250. The second electrode layer 263 may be disposed on the first electrode layer 261, having the organic light-emitting layer 262 formed therebetween. The organic light-emitting layer 262 may include a hole injecting layer, a hole transporting layer, an electron transporting layer and an electron injecting layer.

The second electrode layer 263 of the organic OLED 260 may be formed on the organic light-emitting layer 262 and the pixel-defining film 270. The second electrode layer 263 may be made of the same metal as that of the first electrode layer 261.

As described above, the present invention is advantageous in providing an organic light-emitting display device having a photo sensor with enhanced light absorption rate due to a light blocking layer formed on the passivation layer, thereby providing improved luminance control of the organic light emitting display device. As such, the present invention may advantageously minimize luminance and image quality wear due to organic layer deterioration, thereby enhancing overall quality and lifespan of the organic light-emitting display device.

Exemplary embodiments of the present invention have been disclosed herein, and although specific terms may be employed, they may be used and are to be interpreted in a generic and descriptive sense only and not for purpose of limitation. Accordingly, it will be understood by those of ordinary skill in the art that various changes in form and details may be made without departing from the scope of the present invention as set forth in the following claims.

## Claims

1. An organic light-emitting display device, comprising:
a substrate;
a thin film transistor on the substrate;
a passivation layer on the thin film transistor;
an organic light-emitting diode on the passivation layer and electrically connected to the thin film transistor;
a photo sensor between the substrate and the organic light-emitting diode; and
a light blocking layer on the passivation layer.

2. The organic light-emitting display device as claimed in claim 1, wherein the light blocking layer includes a metal having low reflectivity.

3. The organic light-emitting display device as claimed in claim 2, wherein the metal is molybdenum or chromium.

4. The organic light-emitting display device as claimed in claim 1, 2 or 3, wherein the light blocking layer includes a metal insulator hybrid layer.

5. The organic light-emitting display device as claimed in any one of the preceding claims, wherein the light blocking layer is a single continuous film.

6. The organic light-emitting display device as claimed in any one of claims 1 to 4, wherein the light blocking layer includes a plurality of discontinuous segments.

7. The organic light-emitting display device as claimed in any one of the preceding claims, wherein the light blocking layer is capable of minimizing light interference absorbed by the photo sensor.

8. The organic light-emitting display device as claimed in any one of the preceding claims, wherein the photo sensor is capable of absorbing light emitted from the organic light-emitting diode and converting the absorbed light into electrical signals.

9. The organic light-emitting display device as claimed in claim 8, wherein the electrical signals are capable of controlling luminance of the light generated by the organic light-emitting diode.

10. The organic light-emitting display device as claimed in any one of the preceding claims, wherein the photo sensor is horizontally spaced apart from the thin film transistor.

11. The organic light-emitting display device as claimed in any one of the preceding claims, wherein the organic light-emitting diode has a rear light-emitting structure.

12. The organic light-emitting display device as claimed in any one of the preceding claims, wherein the photo sensor includes an N-type doping region, a P-type doping region spaced apart horizontally from the N-type doping region, and an intrinsic region between the N-type doping region and the P-type doping region.

13. The organic light-emitting display device as claimed in any one of the preceding claims, wherein the organic light-emitting diode includes a first electrode layer, a light-emitting layer and a second electrode layer.

14. A method of manufacturing an organic light-emitting display device, comprising:
forming a thin film transistor on a substrate;
forming a photo sensor on the substrate;
forming a passivation layer on the thin film transistor;
forming an organic light-emitting diode on the passivation layer; and
forming a light blocking layer on the passivation layer.

15. The method of manufacturing an organic light-emitting display device as claimed in claim 14, wherein forming the light blocking layer includes depositing a metal or an opaque insulating material to a thickness of about 100 angstroms (10nm) to about 5000 angstroms (500nm).

16. The method of manufacturing an organic light-emitting display device as claimed in claim 14 or 15, wherein forming the light blocking layer includes depositing a metal having low reflectivity.

17. The method of manufacturing an organic light-emitting display device as claimed in claim 14, 15 or 16, wherein forming the light blocking layer includes depositing a plurality of discontinuous segments on the passivation layer.

18. The method of manufacturing an organic light-emitting display device as claimed in claim 17, wherein each predetermined number of segments of the plurality of segments is arranged into a geometrical shape.

19. The method of manufacturing an organic light-emitting display device as claimed in any one of claims 14 to 16, wherein forming the light blocking layer includes depositing a single continuous layer on the passivation layer.
